# EUROPEAN PATENT SPECIFICATION

(11) **EP 3 848 528 B1**
(45) Date of publication and mention of the grant of the patent: **07.06.2023**
(21) Application number: 21150606.8
(22) Date of filing: 07.01.2021
(51) Int. Cl.: E04F 11/104, F21V 33/00, H01L 41/113, E04F 11/16, H01L 41/193

(54) **IMPROVED SAFETY STAIRCASE AND MULTI-COMPOUND SAFETY ANGULAR PROFILE FOR A USER OF SAID STAIRCASE**
TREPPE MIT VERBESSERTER SICHERHEIT UND MEHRTEILIGES SICHERHEITSPROFIL FÜR EINEN BENUTZER DER TREPPE
ESCALIER AVEC UNE SÉCURITÉ AMÉLIORÉE ET UN PROFIL DE SÉCURITÉ EN PLUSIEURS PARTIES POUR UN UTILISATEUR DE L'ESCALIER

(30) Priority: 08.01.2020 IT 202000000178
(43) Date of publication of application: 14.07.2021
(73) Proprietor: Mazzero Carpenteria & C. S.r.l., 31010 Farra di Soligo (TV) (IT)
(72) Inventor: GIRARDI, Sisto, 31010 Farra di Soligo (TV) (IT)
(74) Representative: Burchielli, Riccardo

(56) References cited:
- WO-A1-2016/125100
- CN-U- 206 844 511
- JP-B2- 4 290 690
- PL-Y1- 67 983
- US-A1- 2001 036 072

## Description

This invention relates to an improved safety staircase for a user and to a multi-compound angular profile as set out in the appended set of claims.

In particular, the invention relates to a staircase equipped with steps, each of which has a multi-compound angular profile and includes LED lights and pressure sensors.

The angular profile is preferably made of aluminium and is designed to cover the 90° angle of the various steps in a staircase in order to allow a user to ascend or descend the stairs of a building.

The angular profile consists of at least two elements, wherein:
- a first element has a shape which provides a first flat or horizontal part fixed on the horizontal plane of the rough concrete and/or brick step, before the laying of tiles and/or other upper finishing material, a second lower part shaped like an upside-down "U", inside which a hollow space is determined in which to insert LEDs or a strip of LEDs, and a third upper part shaped like an "L", arranged at 180°, with the upper external horizontal part parallel to the first flat part, where a seat is made to contain the second element;
- a second element is fixed to the first element and has the function of covering particular pressure sensors and of horizontally completing the multi-compound angular profile.

The first element can be made by drawing aluminium or by moulding plastic polymers, whilst the second element is composed of three sub-elements, where a first, upper, sub-element can be made of aluminium or plastic polymers and/or other finishing material, such as wood, or other material designed to bend, a second, intermediate, sub-element, comprises piezoelectric sensors made from an intermediate film of ferroelectric polymers belonging to the fluoride class PVDF (polyvinylidene fluoride), a base material with strong piezoelectric and pyroelectric activity, to which electrodes based on special ferroelectric polymers are applied, above and below, by means of a low-cost production screen-printing method, and a third, lower, element made from aluminium or plastic polymers.

The first element also provides seats to accommodate the connection wires for the LEDs or the LED strip and the pressure sensors.

The LEDs and piezoelectric pressure sensors are connected to an IOT electronic control unit to manage the switching on and off of the LEDs according to the command provided by the piezoelectric pressure sensors and/or to activate an acoustic signal and/or an emergency call in the event that several piezoelectric pressure sensors are activated simultaneously on several steps, for a predefined period of time (typically longer than one minute), a situation which detects that the user is present and immobile on several steps due to an accident).

Historically, the angular profiles made of plastic polymers or aluminium have been used in building works to protect the edges of parts such as corners of cladding and/or columns and/or steps from breakage.

For this specific application, various models of aluminium angular profiles for staircase steps are currently marketed, which have constructive forms similar to the present invention, and which have LEDs or LED strips positioned inside so as to propagate the light horizontally (reference is made here to the solutions protected by Intellectual Property Rights of the manufacturers "Euroshrink S.A", "Progress Profiles S.p.A." and "Schlüter-Systems Italia S.r.l.") vertically downwards (see here the solutions protected by the Intellectual Property Rights of the manufacturers "Dural GMBh", "Emac Complementos S.I." and "Profilpass S.p.a.").

The latter models are more preferred by users for domestic applications, as the LED light is less invasive.

The angular profiles for steps where the light propagates horizontally are made of either aluminium or plastic polymers and comprise an additional part, normally made of plastic, to cover the LEDs or LED strips.

Staircase profiles where the light propagates vertically downwards are normally made of a single material (aluminium or plastic polymers) and have a single construction element.

In this case, the LEDs are usually glued onto adhesive strips which are then fixed simply be pressing inside the lower part of the angular profile with the real risk of detachment when the ambient and/or operating temperatures change and with the result that the adhesive strip often has to be replaced and fixed again.

The external finish of the angular profiles for steps mentioned above is normally made of a single material (aluminium or plastic polymers), without the possibility of customisation, for example with a wooden part or other finishing material which is identical to the material of the upper part of the step.

For example, US2001/036072A1 relates to a molded or extruded plastic holder and support for lighting along aisles and stairs of a theatre, according to the preamble of claim 1. The extrusions are made so that they can be supported on floors, and will provide smooth access to raised floor portions. The covers are hingedly mounted integrally with the extrusions, and can be snapped into a closed position or lifted up for access to recesses for fiber optic lights, and, for example, wiring or LED lights.

All the types of angular profiles for steps with seats for the LEDs available on the market and indicated above only have the function of illuminating the steps of the staircase, in order to prevent any possible accidents by the users and the LEDs are normally switched on or off by means of a switch placed at the beginning and/or at the end of the staircase, whilst it would be more eco-friendly and economical to switch off the LEDs after passing each step.

In order to overcome these problems (of a qualitative and aesthetic nature, as well as related to energy saving and to the increase of the functions in terms of safety for the user of the staircase), the solution identified by the invention is to make a new multi-compound angular profile for steps, in which, in the lower part of a first element, a seat is provided for receiving and stably fixing LEDs or a strip of LEDs, and in the upper part, a lowered seat is provided for receiving a second element comprising piezoelectric pressure sensors and having lowered seats for receiving the wires for connection of the same electrical/electronic components (LEDs and piezoelectric pressure sensors) to an IOT electronic control unit installed in the building where the staircase is located, in order to create a system that allows an automatic and more economical management of the electrical energy used to activate the LEDs or the LED strip, ensuring savings in energy consumption.

In addition, the special type of sensors used (piezoelectric), which do not require an electricity power supply, means that energy consumption is lower than with the LED step profiles still currently used.

Furthermore, the second element of the multi-compound angular profile according to the invention allows for the superficial reception of other materials, such as wood and/or other material capable of bending, for appearance purposes, so as to allow for various degrees of customisation by the owner of the staircase or building (a customisation which is not possible at present using the step profiles currently available on the market). Another aim of the invention is to set up a safety system for people using the staircase equipped with the new multi-compound angular profile, since, thanks to the piezoelectric pressure sensors, not only the functions of turning on and off the LEDs or a strip of LEDs are automatically managed, but, by means of a software present in the IOT control unit to which they are connected, it is possible to identify any abnormal situations, such as, in particular, the simultaneous activation of several piezoelectric pressure sensors for a pre-set and programmable period time beyond the normal walking (this means the identification of a person who is immobile due to an accidental event, such as a fall) with the consequent activation of an acoustic signal and/or an emergency call to one or more pre-set numbers. This safety function is extremely important in the case of elderly people living alone in the house or building and/or if the angular profile is installed in health centres and/or care homes for the elderly or people with disabilities.

Further features and advantages of the invention will be more evident from the following description of a preferred, non-limiting, example embodiment of a multi-compound angular profile, made in two elements and designed for incorporating LEDs or an LED strip and one or more piezoelectric pressure sensors connectable to an IOT electronic control unit, for an automatic management of switching on or off of the LEDs or an LED strip and for a safety function for the user of the staircase to which the multi-compound angular profile is fixed, according to the invention.

The above-mentioned technical features and advantages are also evident from the accompanying drawings, also provided by way of a preferred, non-limiting example, wherein:

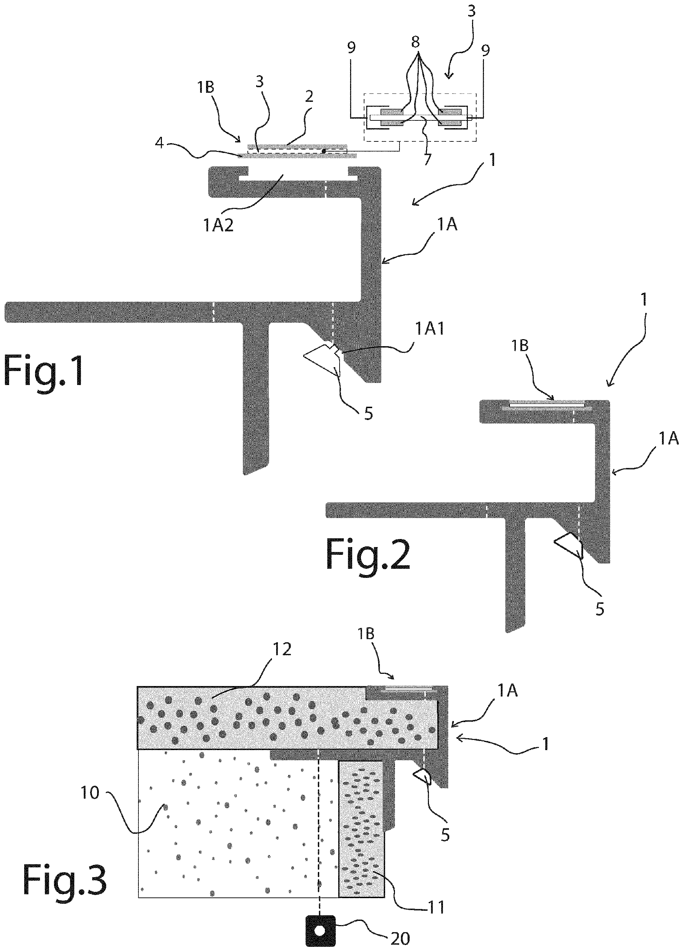

- Figure 1 shows an exploded view of a section of the multi-compound angular profile including the various components, according to the invention;
- Figure 2 shows a cross-sectional view of the multi-compound angular profile assembled in its two main elements according to the invention;
- Figure 3 shows a cross-sectional view of the multi-compound angular profile fixed to the step of a staircase according to the invention;

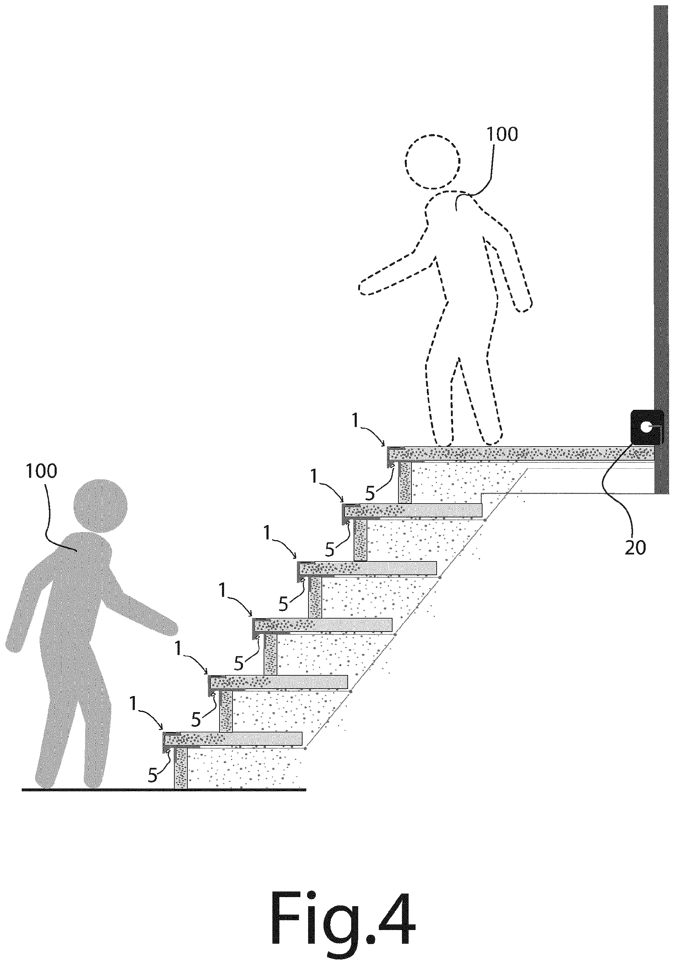

- Figure 4 shows a cross-sectional view of a staircase with the steps including the multi-compound angular profiles, with associated LEDs or strips of LEDs and piezoelectric pressure sensors connected to an loT electronic control unit, according to the invention (in this case, the user is in a position where he/she ascends or descends the staircase and the LED lights are off);

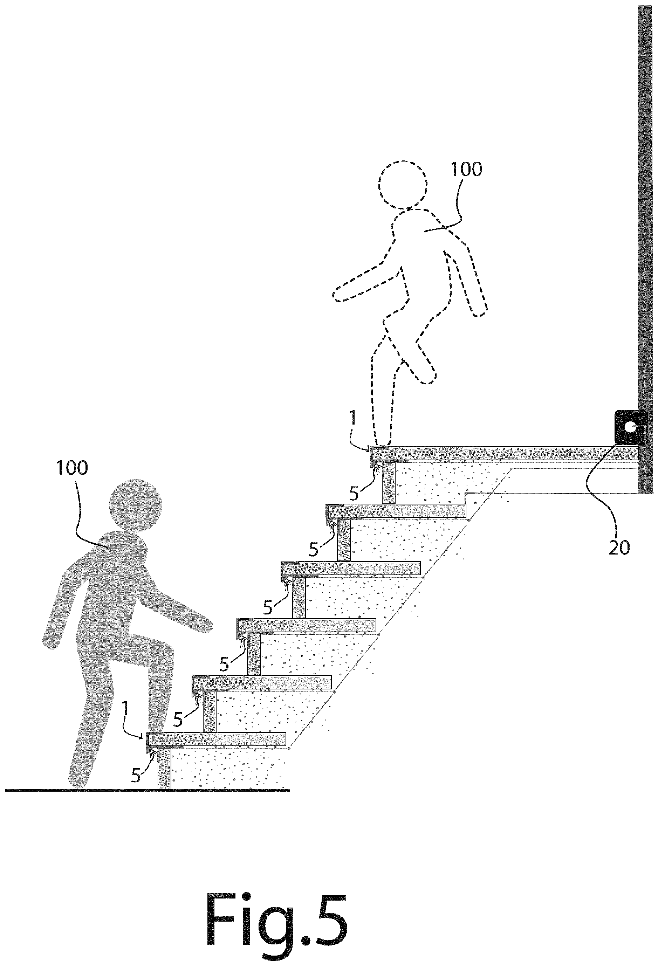

- Figure 5 shows a cross-sectional view of a staircase with the steps including the multi-compound angular profiles, with associated LEDs or strips of LEDs and piezoelectric pressure sensors connected to an loT electronic control unit, according to the invention (in this case, the user has placed the foot on the multi-compound angular profile of the first step to ascend or descend the staircase and the LED lights are automatically all switched on);

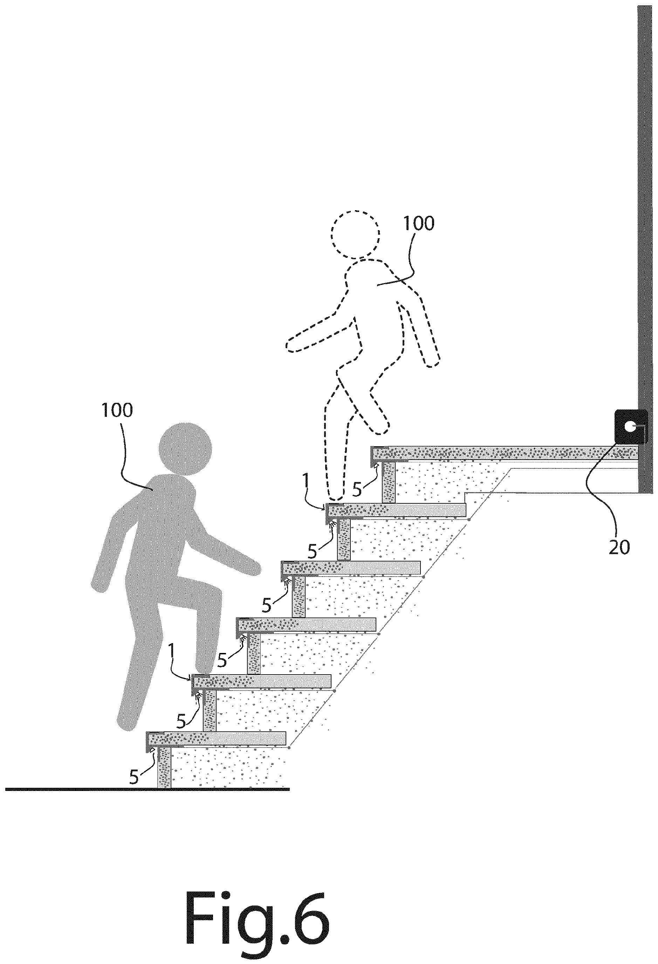

- Figure 6 shows a cross-sectional view of a staircase with the steps including the multi-compound angular profiles, with associated LEDs or strips of LEDs and piezoelectric pressure sensors connected to an loT electronic control unit, according to the invention (in this case, the user has placed the foot on the multi-compound angular profile of the second step to ascend or descend the staircase and the LED lights active on the first or previous step are automatically switched off);

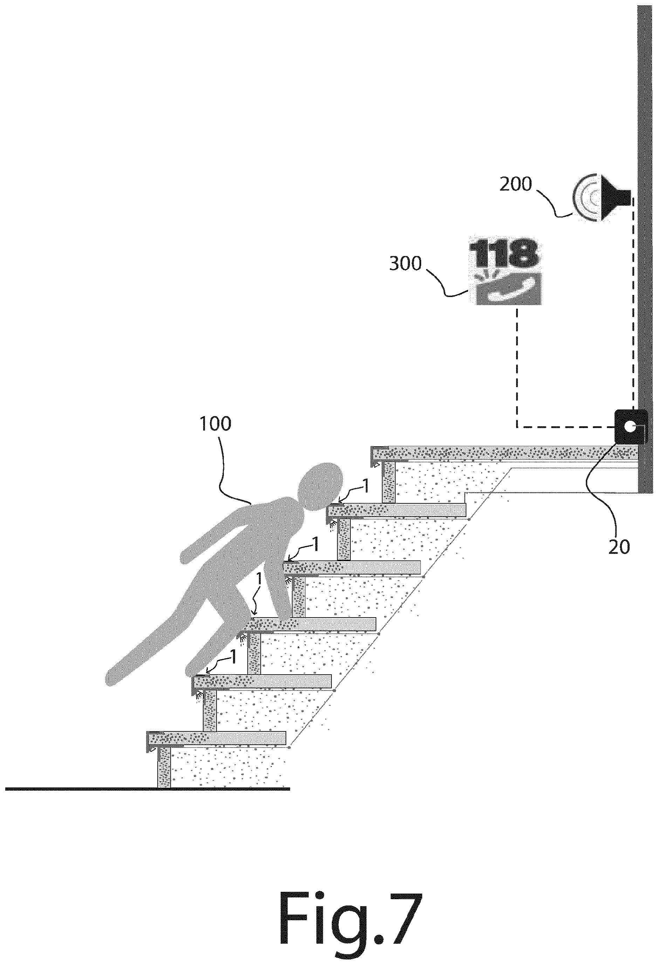

- Figure 7 shows a cross-sectional view of a staircase with the steps including the multi-compound angular profiles, with associated LEDs or strips of LEDs and piezoelectric pressure sensors connected to an loT electronic control unit, according to the invention (in this case, the user has positioned his/her body on several multi-compound angular profiles to signify a possible accident and/or fall and, therefore, if the piezoelectric pressure sensors remain activated for a period of time longer than a predetermined time, for example longer than one minute, the loT control unit emits a local acoustic signal and/or sends an emergency call, as the user cannot move his/her body and needs assistance).

With reference to the above-mentioned drawings, the new multi-compound angular profile (1) for steps of staircases according to the invention is fixed on each rough step (10) and a riser (11) and a horizontal covering element (12) made of any material of various appearances (for example, marble, granite, wood, tiles, etc.) are then fixed on the rough step (10).

The multi-compound angular profile (1) consists of a first element (1A), preferably made of aluminium, which is fixed in contact with the riser (11) of the step (10) and which allows one or more LEDs or an LED strip (5) to be fixed in a stable manner in its interior lower portion, thanks to the presence of a lowered seat (1A1).

In the upper and horizontal part of the first element (1A), which is fixed on the same plane as the covering element (12), there is a lowered seat (1A2) for receiving a second element (1B) of the multi-compound angular profile (1), which is composed of three sub-elements, wherein a first upper sub-element (2) may be made of aluminium or plastic polymers or other finishing material, such as wood or other material designed to bend, a second intermediate sub-element (3) includes piezoelectric pressure sensors (9) made from an intermediate film (7) of ferroelectric polymers belonging to the PVDF (polyvinylidene fluoride) class of fluorides and/or a base material with strong piezoelectric and pyroelectric activity, to which electrodes (8) based on special ferroelectric polymers are applied above and below, preferably by a screen printing method, and a third lower sub-element (4) is made of aluminium or plastic polymers.

The three sub-elements are sandwiched together by gluing or other mechanical system and form the second element (1B), which is assembled to the first element (1A), inside the lowered seat (1A2), thus forming the multi-compound angular profile (1).

The special sandwich construction of the second element (1B) allows the activation, after a pressure is actuated on it, of piezoelectric pressure sensors (9), which are connected, like the LEDs or the LED strip (5), to an loT electronic control unit (20) delegated to the electrical and electronic management of an on/off system and a passive safety system.

The above-mentioned multi-compound angular profile (1), equipped with LEDs or LED strips (5) and piezoelectric pressure sensors (9) connected to the loT electronic control unit (20), makes it possible to automatically switch the LEDs (5) on and off, as well as to detect any abnormal situations or situations resulting from a possible accident which may occur to the user (100) of the staircase.

In operational terms, the multi-compound angular profile (1) thus created and associated with the various steps of a staircase makes it possible to:
a) switch on all the LED lights (5) present on each angular profile (1) of the staircase when the user (100) places his/her foot on the second element (1B) of the multi-compound profile (1) present on the first step (10), during ascent or descent, thanks to the activation of the piezoelectric pressure sensors (9) located on the second element (1B) of the first step (10) and connected to the loT electronic control unit (20);
b) switch off the LED light (5) of the step just passed, during ascent or descent, thanks to the deactivation of the piezoelectric pressure sensors (9) located on the second element (1B) of the step (10) passed and connected to the loT electronic control unit (20);
c) activate a local acoustic signal (200) and subsequently send an emergency call (300) if the piezoelectric pressure sensors (9) in at least two multi-compound angular profiles (1) are simultaneously activated; in particular, the acoustic signal (200) and the emergency call (300) are activated when the piezoelectric pressure sensors (9) remain activated for a predetermined period of time, which is longer than the normal time for ascent or descent by a user (100), since, in such a case, it is possible that the above-mentioned user (100) has had an accident and is no longer able to move and/or to call for help.

The invention may be modified in several ways without departing from the scope of the invention as defined in the appended claims.

Where the characteristics and the techniques mentioned in the following claims are followed by reference signs, the reference signs have been used only with the aim of increasing the intelligibility of the claims themselves and, consequently, the reference signs do not constitute in any way a limitation to the interpretation of each element identified, purely by way of example, by the signs numbers.

## Claims

1. A multi-compound angular profile (1) comprising a first element (1A) fixable to a raised part (11) of a step (10) of a staircase and provided with a lower inner portion, said first element (1) having a first lowered seat (1A1), on which one or more LEDs or a strip of LEDs (5) are stably positioned, and a second element (1B), placed inside a second lowered seat (1A2), which is formed in an upper and horizontal portion of said first element (1A) such that it would be coplanar to a horizontal covering element (12) of a step of a staircase on which said angular profile (1) is fixed, said second element (1B) being composed of a plurality of sub-elements,
**characterised in that** said plurality of sub-elements comprises
a first upper sub-element (2) made of aluminum or plastic polymers or other finishing materials, a second intermediate sub-element (3) including piezo-electric sensors (9) made from an intermediate film (7) of ferro-electric polymers and/or a base material with piezo-electric and pyro-electric activity, on which electrodes (8) based on ferro-electric polymers are applied, and a third lower sub-element (4) is made of aluminum or plastic polymers, said second element (1B) being assembled inside said second lowered seat (1A2) of said first element (1A).

2. An improved safety staircase, comprising a plurality of steps (10), each of which having a raised part (11) and a horizontal covering element (12), and respective multi-compound angular profiles (1) according to claim 1, each of which being fixed to a single step (10), wherein said first element (1A) of each of said multi-compound angular profiles (1) is placed in contact with said raised part (11) of the step (10) and said upper and horizontal portion of said first element (1A) is coplanar to saic horizontal covering element (12).

3. The improved safety staircase according to claim 2, wherein said sub-elements are sandwich-assembled by gluing or other mechanical system.

4. The improved safety staircase according to at least one of the previous claims 2 and 3, wherein said piezo-electric pressure sensors (9) are activated when pressure is exerted on said second element (1B).

5. The improved safety staircase according to at least one of the previous claims from 2 to 4, wherein said piezo-electric pressure sensors (9) and said LEDs or strip of LEDs (5) are connected to an loT electronic control unit (20), which is configured to manage electrically and electronically a system for automatically switching on or off said LEDs or strip of LEDs (10) and a passive safety system.

6. The improved safety staircase according to claim
5, wherein said LEDs or strip of LEDs (5) are turned on when a user (100) places a foot on said second element (1B) of the angular profile (1) fixed to a first step (10), during the ascent or descent of said staircase, through an automatic activation of said piezo-electric pressure sensors (9) of said second element (1B) of the angular profile (1) fixed to said first step (10), said automatic activation being driven by said IoT electronic control unit (20).

7. The improved safety staircase according to at least one of the previous claims 5 and 6, wherein said LEDs or strip of LEDs (5) are turned off when a step (10) is exceeded by said user (100), said turning off being performed through an automatic deactivation of said piezo-electric pressure sensors (9) of said second element (1B) of the angular profile (1) of the exceeded step (10), said automatic deactivation being driven by said IoT electronic control unit (20).

8. The improved safety staircase according to at least one of the previous claims from 5 to 7, wherein a simultaneous activation of said piezo-electric pressure sensors (9) present in at least two of said multi-compound angular profiles (1) causes the activation of an acoustic signal (200) and of a following emergency call (300), by means of said loT electronic control unit (20), said simultaneous activation of said piezo-electric pressure sensors (9) being carried out for a prefixed time period, which is higher than an average time period for the user (100) to ascend or descend said staircase.

9. The improved safety staircase according to at least one of the previous claims from 2 to 8, wherein said horizontal covering element (12) of said step (10) is made of marble, granite, wood, tiles, etc., while said first element (1A) of said multi-compound angular profile (1) is made of aluminum.

10. The improved safety staircase according to at least one of the previous claims from 2 to 9, wherein said finishing materials, with which said first upper sub-element (2) of said second element (1B) is made, are wood or other flexible materials.

## Patentansprüche

1. Mehrverbund-Winkelprofil (1) umfassend ein erstes Element (1A), das an einem erhöhten Teil (11) einer Stufe (10) einer Treppe anbringbar ist, versehen mit einem unteren inneren Teil, das besagte erste Element (1) hat einen ersten abgesenkten Sitz (1A1), auf dem eine oder mehrere LEDs oder ein LED-Streifen (5) stabil positioniert sind, und ein zweites Element (1B), platziert innerhalb eines zweiten abgesenkten Sitzes (1A2), der in einem oberen und horizontalen Abschnitt des ersten Elements (1A) gebildet ist, derart, dass es koplanar zu einem horizontalen Abdeckelement (12) einer Stufe einer Treppe wäre, auf der das besagte Winkelprofil (1) befestigt ist, wobei das zweite Element (1B) zusammengesetzt ist aus einer Vielzahl von Unterelementen, **dadurch gekennzeichnet, dass** die besagte Vielzahl von Unterelementen ein erstes oberes Teilelement (2) umfasst, das aus Aluminium- oder Kunststoffpolymer oder anderen Veredelungsmaterialien besteht, ein zweites Zwischenelement (3) einschließlich piezoelektrischer Sensoren (9) aus einer Zwischenfolie (7) aus ferroelektrischen Polymeren und/oder einem Grundmaterial mit piezoelektrischer und pyroelektrischer Aktivität, auf welchen Elektroden (8) auf Basis von ferroelektrischen Polymeren aufgebracht werden, und ein drittes unteres Teilelement (4), aus Aluminium oder Kunststoffpolymeren hergestellt, wobei das besagte zweite Element (1B) innerhalb des zweiten abgesenkten Sitzes (1A2) des besagten ersten Elements (1A) montiert ist.

2. Eine verbesserte Sicherheitstreppe, die jeweils mehrere Stufen (10) umfasst, jede davon mit einem erhöhten Teil (11) und einem horizontalen Abdeckelement (12), und jeweils Mehrverbund-Winkelprofile (1) nach Anspruch 1, von denen jedes an einer einzigen Stufe (10) befestigt ist, wobei das besagte erste Element (1A) jedes der besagten Mehrverbund-Winkelprofile (1) Kontakt hat mit dem erhöhten Teil (11) der Stufe (10), und besagter oberer und horizontaler Abschnitt des ersten Elements (1A) ist koplanar zu dem besagten horizontalen Abdeckelement (12).

3. Verbesserte Sicherheitstreppe nach Anspruch 2, wobei die besagten Teilelemente durch Kleben oder andere mechanische Systeme sandwichartig zusammengebaut werden.

4. Verbesserte Sicherheitstreppe nach mindestens einem der vorhergehenden Ansprüche 2 und 3, wobei die besagten piezoelektrischen Drucksensoren (9) aktiviert werden, wenn Druck auf das besagte zweite Element (1B) ausgeübt wird.

5. Verbesserte Sicherheitstreppe nach mindestens einem der vorhergehenden Ansprüche 2 bis 4, wobei die besagten piezoelektrischen Drucksensoren (9) und die LEDs oder LED-Streifen (5) mit einer IoT-Elektronik- Steuereinheit (20) verbunden sind, die konfiguriert ist, elektrisch und elektronisch ein System zum automatischen Ein- oder Ausschalten der besagten LEDs oder LED-Streifen (10) und ein passives Sicherheitssystem zu verwalten.

6. Verbesserte Sicherheitstreppe nach Anspruch 5, wobei die besagten LEDs oder LED-Streifen (5) eingeschaltet werden, wenn ein Benutzer (100) einen Fuß auf das besagte zweite Element (1B) des an einer ersten Stufe (10) befestigten Winkelprofils (1) setzt, während des Aufstiegs oder Abstiegs auf der besagten Treppe durch eine automatische Aktivierung der besagten piezoelektrischen Drucksensoren (9) des zweiten Elements (1B) des Winkelprofils (1), das an der besagten ersten Stufe (10) befestigt ist, wobei die besagte automatische Aktivierung von dem besagten IoT-elektronischen Steuergerät (20) besorgt wird.

7. Verbesserte Sicherheitstreppe nach mindestens einem der vorhergehenden Ansprüche 5 und 6, wobei die besagten LEDs oder LED-Streifen (5) abgeschaltet werden, wenn eine Stufe (10) vom Benutzer (100) überschritten wird, wobei das Abschalten durch eine automatische Deaktivierung der besagten piezoelektrischen Drucksensoren (9) des zweiten Elements (1B) des Winkelprofils (1) der überschrittenen Stufe (10) erfolgt, wobei die besagte automatische Deaktivierung vom besagten IoT-elektronischen Steuergerät (20) besorgt wird.

8. Verbesserte Sicherheitstreppe nach mindestens einem der vorhergehenden Ansprüche 5 bis 7, wobei die gleichzeitige Aktivierung der besagten piezoelektrischen Drucksensoren (9), welche in wenigstens zwei der besagten Mehrverbund-Winkelprofile (1) die Aktivierung eines akustischen Signals (200) und eines nachfolgenden Notfall-Anrufs (300) auslöst, mithilfe des besagten elektronischen IoT-Steuergeräts (20), die besagte gleichzeitige Aktivierung der besagten piezoelektrischen Sensoren (9) wird für einen vorher festgelegten Zeitraum durchgeführt, der länger ist als die durchschnittliche Zeit, die ein Benutzer (100) benötigt, die besagte Treppe hinauf- oder herabzusteigen.

9. Verbesserte Sicherheitstreppe nach mindestens einem der vorhergehenden Ansprüche 2 bis 8, wobei besagtes horizontales Abdeckelement (12) besagter Stufe (10) aus Marmor, Granit, Holz, Fliesen usw. besteht, während das besagte erste Element (1A) des besagten Mehrverbund-Winkelprofils (1) aus Aluminium hergestellt ist.

10. Verbesserte Sicherheitstreppe nach mindestens einem der vorhergehenden Ansprüche 2 bis 9, wobei besagte Veredelungsmaterialien, mit denen das besagte erste obere Teilelement (2) des besagten zweiten Elements (1B) hergestellt ist, aus Holz oder anderen flexiblen Materialien bestehen.

## Revendications

1. Un profil angulaire à plusieurs composants (1) comprend un premier élément (1A) fixable à une partie surélevée (11) d'une étape (10) d'un escalier et fourni avec une partie intérieure inférieure, ledit premier élément (1) ayant un premier siège abaissé (1A1), sur lequel une ou plusieurs LEDs ou une bande de diodes électroluminescentes (5) sont positionnés de manière stable, et un second élément (1B), est placé à l'intérieur du second siège abaissé (1A2), qui est formé dans une partie supérieure et horizontale dudit premier élément (1A) de sorte qu'il serait co-planaire à un élément de recouvrement horizontal (12) d'une étape d'un escalier sur lequel ledit profile angulaire (1) est fixé, ledit second élément (1B) étant composé d'une pluralité de sous-éléments, **caractérisés par le fait que** ladite pluralité de sous-éléments comprend un premier sous-élément supérieur (2) fait d'aluminium ou de polymères plastiques ou d'autres matériaux de finition, un second sous-élément intermédiaire (3) y compris les capteurs piézo-électriques (9) fait à partir d'un film intermédiaire (7) de polymères ferroélectriques et/ou un matériau de base avec une activité piézo-électrique et pyroélectrique, sur lequel les électrodes (8) fondées sur des polymères ferroélectriques sont appliquées, et un troisième sous-élément inférieur (4) fait d'aluminium ou de polymères plastiques, ledit second élément (1B) étant assemblé à l'intérieur dudit second siège abaissé (1A2) dudit premier élément (1A).

2. Un escalier de sécurité amélioré, comprenant une pluralité d'étapes (10), dont chacune ayant une partie surélevée (11) et un élément de recouvrement horizontal (12), et des profils angulaires multicomposés respectifs (1) selon la revendication 1, chacune étant fixé à une seule étape (10), où ledit premier élément (1A) de chacun de ces profils angulaires composés multiples (1) est en contact avec ladite partie surélevée (11) de l'étape (10) et ladite partie supérieure et horizontale dudit premier élément (1A) est coplanaire dudit élément de recouvrement horizontal (12).

3. L'escalier de sécurité amélioré selon la revendication 2, où lesdits sous-éléments sont assemblés en sandwich en collant ou par un autre système mécanique.

4. L'escalier de sécurité amélioré selon au moins une des revendications précédentes 2 et 3, où lesdits capteurs de pression piézo-électriques (9) sont activés lorsque la pression est exercée sur ledit second élément (1B).

5. L'escalier de sécurité amélioré selon au moins une des revendications précédentes à partir des revendications 2 à 4, où lesdits capteurs de pression piézo-électrique (9) et lesdites LEDs et bandes de LEDs (5) sont connectés à une unité de contrôle électronique IoT (20), qui est configurée pour gérer un système de manière électrique et électronique pour allumer ou éteindre de manière automatique lesdites LEDs ou les bandes de LEDs (10) et un système passif de sécurité.

6. L'escalier de sécurité amélioré selon la revendication où lesdites LEDs ou bandes de LEDs (5) sont allumées lorsqu'un utilisateur (100) place un pied sur ledit second élément (1B) du profil angulaire (1) fixé sur la première étape (10), lors de la montée ou la descente dudit escalier, à travers une activation automatique des capteurs de pression piézo-électrique (9) dudit second élément (1B) du profil angulaire (1) fixé sur ladite première étape (10), ladite activation automatique étant actionnée par ladite unité de contrôle électronique (20).

7. L'escalier de sécurité amélioré selon au moins une des revendications précédentes 5 et 6, où les LEDs ou bandes de LEDs (5) sont éteintes lorsqu'une étape (10) est dépassée par ledit utilisateur (100), ladite extinction étant exécutée à travers une désactivation automatique desdits capteurs de pression piézo-électriques (9) dudit second élément (1B) du profile angulaire (1) de l'étape dépassée (10), ladite désactivation automatique étant actionnée par ladite unité de contrôle électronique IoT (20).

8. L'escalier de sécurité améliorée selon au moins des revendications précédentes à partir des revendications 5 à 7, où une activation simultanée desdits capteurs de pression piézo-électrique (9) présents dans au moins deux des profils angulaires à plusieurs composants (1) entraîne l'activation d'un signal acoustique (200) et d'un appel d'urgence suivant (300), au moyen d'une unité de contrôle électronique IoT (20), ladite activation simultanée des capteurs de pression piézo-électriques (9) étant exécutée pour une période préfixée, qui est supérieure à une période moyenne pour l'utilisateur (100) pour monter ou descendre ledit escalier.

9. L'escalier de sécurité améliorée selon au moins les revendications précédentes à partir des revendications 2 à 8, où ledit élément de recouvrement horizontal (12) de ladite étape (10) est fait de marbre, granite, bois, carreaux, etc., tandis que le premier élément (1A) dudit profil angulaire à plusieurs composants (1) est fait d'aluminium.

10. L'escalier de sécurité améliorée selon au moins une des revendications précédentes à partir des revendications 2 à 9, où lesdits matériaux de finition, avec lesquels ledit premier sous-élément supérieur (2) dudit second élément (1B) est fait, de bois ou d'autres matériaux flexibles.
